# EUROPÄISCHE PATENTSCHRIFT

(11) **EP 1 281 305 B1**
(45) Veröffentlichungstag und Bekanntmachung des Hinweises auf die Patenterteilung: **12.07.2006**
(21) Anmeldenummer: 01943042.0
(22) Anmeldetag: 09.05.2001
(51) Int. Cl.: H05K 13/08

(54) **FERTIGUNGSLINIE FÜR DIE EINSEITIGE UND DOPPELSEITIGE BESTÜCKUNG VON LEITERPLATTEN**
PRODUCTION LINE FOR ONE-SIDED AND TWO-SIDED ASSEMBLY OF PRINTED CIRCUIT BOARDS
CHAINE DE PRODUCTION DESTINEE A L'EQUIPEMENT UNILATERAL OU BILATERAL DE PLAQUETTES DE CIRCUITS IMPRIMES

(30) Priorität: 12.05.2000 DE 10023358
(43) Veröffentlichungstag der Anmeldung: 05.02.2003
(73) Patentinhaber: SIEMENS AKTIENGESELLSCHAFT, 80333 München (DE)
(72) Erfinder: GEITZ, Andreas, 90617 Puschendorf (DE); KRAPS, Uwe, 91077 Neunkirchen (DE)
(86) Internationale Anmeldenummer: PCT/DE2001/001759
(87) Internationale Veröffentlichungsnummer: WO 2001/087035

(56) Entgegenhaltungen:
- US-A- 5 678 304
- "LINE 4 - TYPE III ASSEMBLY" ELECTRONIC PACKAGING AND PRODUCTION, CAHNERS PUBLISHING CO, NEWTON, MASSACHUSETTS, US, Bd. 36, Nr. 2, 1. Februar 1996 (1996-02-01), Seite 29,31 XP000557191 ISSN: 0013-4945
- SMITHEY H: "BREAK AWAY FIDUCIAL LOCATING MARKS" MOTOROLA TECHNICAL DEVELOPMENTS, MOTOROLA INC. SCHAUMBURG, ILLINOIS, US, Bd. 35, Juni 1998 (1998-06), Seiten 193-197, XP000862672
- KUHNAPFEL M ET AL: "FLEXIBEL UND EFFIZIENT BESTUCKEN" F & M. FEINWERKTECHNIK MIKROTECHNIK MESSTECHNIK, CARL HANSER GMBH, MUNCHEN, DE, Bd. 101, Nr. 11/12, 1. November 1993 (1993-11-01), Seiten 433-435, XP000411566 ISSN: 0944-1018

## Beschreibung

Fertigungslinie für die einseitige und doppelseitige Bestückung von Leiterplatten

Die Erfindung betrifft eine Fertigungslinie für die einseitige und doppelseitige Bestückung von Leiterplatten mit Bauelementen, wobei die Fertigungslinie aus zwei aufeinanderfolgenden Abschnitten besteht, die jeweils in Durchlaufrichtung der Leiterplatten einen Drucker, wenigstens ein Bestückmodul und einen Lötofen umfassen, wobei zwischen den beiden Abschnitten eine Wendestation angeordnet ist.

Eine derartige Fertigungslinie ist in dem Dokument Smithey H: "Break away Fiducial Locating Marks", Motorola Technical Developments, Motorola Inc. Schaumburg, Illinois, US, Bd. 35, Juni 1998 (1998-06), seiten 193-197, XP 000 862 672 offenbart.

In einfachster Konfiguration besteht ein Abschnitt einer solchen Fertigungslinie aus wenigstens einem Drucker, wenigstens einem Bestückmodul für die automatische Positionierung von Bauelementen auf der die Linie durchlaufenden Leiterplatte und einem Lötofen. Da die Ausgestaltung der Bestückmodule je nach den zu handhabenden Bauelementen variiert, weil es z.B. Bestückautomaten gibt, die nur passive Bauelemente, wie Widerstände, Kondensatoren etc., handhaben, während andere Bestückautomaten im wesentlichen ICs mit hoher Genauigkeit positionieren, muß bei einer gemischten Bestückung die Fertigungslinie in der Regel zwei oder mehr unterschiedliche Bestückungsmodule umfassen. Sollen mit der Fertigungslinie wahlweise unterschiedliche Bestückungsaufgaben bewältigt werden, muß die Fertigungslinie alle Bestückmodule aufweisen, die für diese Aufgaben benötigt werden.

Dabei gibt es bei der Konfiguration von Fertigungslinien zum Teil Probleme hinsichtlich der Austaktung der einzelnen Bestückmodule, wenn man folgenden Anforderungen entsprechen will:
Fertigungsmix zwischen einseitig zu bestückenden und doppelseitig zu bestückenden Baugruppen, wobei die doppelseitige Bestückung nach Möglichkeit in einem einzigen Durchlauf durch die Fertigungslinie, d.h. ohne Rückführung und zweiten Durchlauf, erfolgen soll,
- Produktmix mit sehr unterschiedlichem Bestückungsinhalt, d.h. große Variationsbreite des Verhältnisses zwischen aktiven und passiven Bauelementen.

Bisher sind für eine doppelseitige Bestückung zwei Verfahrensweisen bekannt:

Bei der ersten Verfahrensvariante wird die Baugruppe während eines ersten Durchlaufs durch eine einzelne Fertigungslinie auf der einen Seite bestückt, worauf die die Fertigungslinie verlassende, einseitig bestückte Baugruppe an den Eingang der Fertigungslinie zurücktransportiert und dann während eines zweiten Durchlaufs durch die Fertigungslinie auf der anderen Seite bestückt wird. Eine typische Fertigungslinie dieser Art mit drei verschiedenen Bestückmodulen und dem üblichen Reflow-Ofen in Form eines Tunnelofens erreicht dabei etwa eine Länge von etwa 20 m.

Bei der zweiten Variante werden zwei gleiche Fertigungslinien zu einer kombinierten Fertigungslinie hintereinander geschaltet, so daß der Rücktransport entfällt und die Bestückung der anderen Seite während des Durchlaufs der Baugruppe durch die zweite Fertigungslinie erfolgt. Für die Herstellung einer einseitig bestückten Baugruppe kann nur die erste der beiden miteinander kombinierten, gleichen Fertigungslinien genutzt werden.

Bei den bekannten Verfahrensweisen sind die Fertigungslinien nur auf spezielle Produkte optimiert, d.h. die Flexibilität - der Fertigungslinien ist gering. Bei den hintereinander geschalteten Fertigungslinien weist jede dieser beiden Fertigungslinien die gleiche Ausstattung mit Bestückmodulen auf, d.h. durch die Verdoppelung der Fertigungslinien verdoppelt sich auch die Zahl der Bestückmodule und es verdoppelt sich auch die Gesamtlänge der kombinierten Fertigungslinie auf etwa 40 m.

Der Erfindung liegt deshalb die Aufgabe zugrunde, eine neuartige Fertigungslinie zu entwickeln, die sich bei hoher Fertigungs- und Produktflexibilität gleichermaßen für einseitige wie auch für doppelseitige Bestückung von Baugruppen im kombinierten Betrieb und bei einmaligem Durchlauf eignet, eine möglichst gute Austaktung der Bestückmodule und damit eine hohe Leistung ermöglicht, von der Baulänge her etwa im Rahmen dessen bleibt, was bei den bisher gebräuchlichen, einzelnen Fertigungslinien erforderlich ist, und vom Bauaufwand her besonders kostengünstig ist.

Diese Aufgabe wird durch die Erfindung gemäß Anspruch 1 gelöst.

Weil die beiden aufeinanderfolgenden Abschnitte insgesamt nur die gleiche Anzahl von Bestückmodulen aufweisen, wie sie bei der oben beschriebenen herkömmlichen Verfahrensweise in jedem einzelnen Abschnitt der Fertigungslinie anzutreffen ist, reduziert sich die Gesamtlänge der aus zwei Abschnitten bestehenden Fertigungslinie beachtlich. Gleichermaßen verringert sich auch der Kostenaufwand.

Die erfindungsgemäße Fertigungslinie ermöglicht es, in einem Durchgang einseitig und doppelseitig bestückte Baugruppen herzustellen, beliebige Anordnungen der Bauelemente auf den beiden Seiten vorzusehen, sofern nur die in der Fertigungslinie vorhandenen Bestückmodule die Bestückung mit diesen Bauelementen gestatten. Die näheren Einzelheiten ergeben sich aus der Figurenbeschreibung.

Vorteilhafte Weiterbildungen der Erfindung sind in den Unteransprüchen gekennzeichnet.

Die Verwendung von Vertikal-Reflow-Öfen anstelle der bisher eingesetzten Tunnelöfen bei einer bevorzugten Ausgestaltung der Erfindung trägt ebenfalls zur spürbaren Verkürzung der Gesamtlänge bei. Der besondere Vorteil der Vertikal-Reflow-Öfen wirkt sich jedoch bei der Steigerung der Flexibilität aus und liegt darin begründet, daß sie während des Betriebs der Fertigungslinie ständig voll beheizt werden können und doch ihre Lötwirkung je nach Produkt bedarfsgemäß selektiert werden kann, weil sie nur im unteren Bereich löten. Führt man eine nur auf der Oberseite bestückte Baugruppe durch den Vertikal-Reflow-Ofen, unterbleibt die Lötwirkung.

Eine besonders vorteilhafte Weiterbildung, wonach auf den zweiten Lötofen eine Wendestation folgt, erleichtert den Betrieb mit zweimaligem Durchlauf der Fertigungslinie, um die größtmögliche Produktflexibilität zu erreichen.

Im folgenden wird die Erfindung anhand von in der Zeichnung dargestellten Ausführungsbeispielen näher erläutert.
- Figur 1: stellt zum Vergleich eine übliche Fertigungslinie gemäß dem Stand der Technik dar;
- Figur 2: zeigt eine erfindungsgemäße Fertigungslinie mit zwei aufeinanderfolgenden Abschnitten, wobei der Betrieb nach einer ersten Bestückungsvariante mit einmaligem Durchlauf dargestellt ist; und
- Figur 3: zeigt die in Figur 2 gezeigte Fertigungslinie während des Betriebs nach einer zweiten Bestückungsvariante mit zweimaligem Durchlauf der Fertigungslinie.

Bei den dargestellten Fertigungslinien werden als Bestückautomaten jeweils die gleichen Standardmodule eingesetzt, und zwar sind die Fertigungslinien beispielsweise mit den Siemens-Erzeugnissen Siplace HS50, Siplace 80S23HM und Siplace 80F5HM ausgestattet, von welchem der Bestückautomat Siplace HS50 nur passive Bauteile, wie Widerstände, Kondensatoren, etc., handhabt, während der Bestückautomat Siplace 80F5HM im wesentlichen zur Handhabung von ICs mit hoher Genauigkeit ("fine pitch") dient.

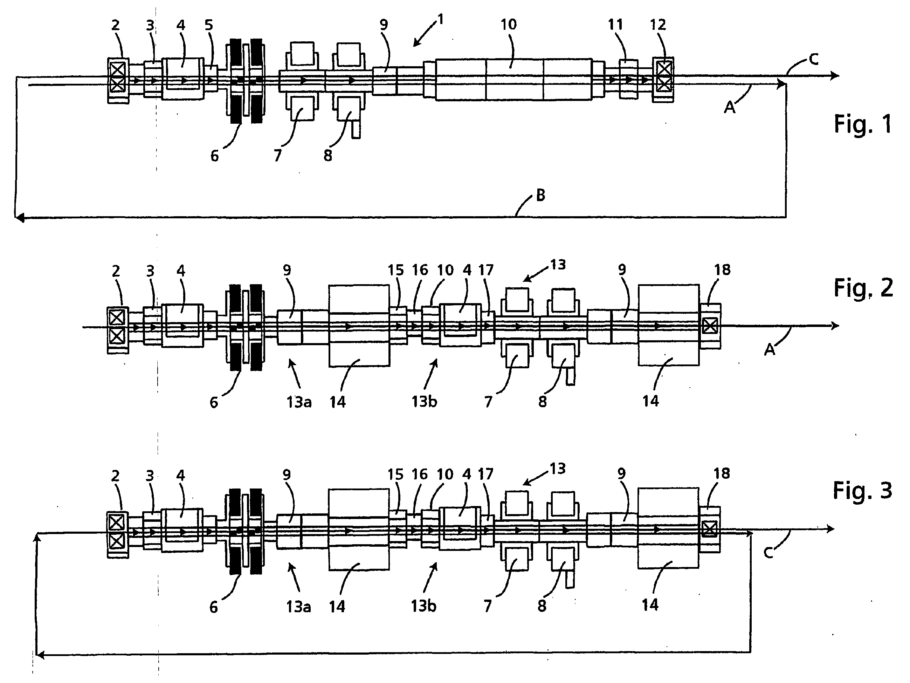

Die in Figur 1 gezeigte Fertigungslinie 1 nach dem Stand der Technik beginnt mit einer Magazineingabe 2, auf die ein Leiterplattenentstapler 3 folgt. Die einzelnen Leiterplatten werden durch einen Drucker 4 geführt, der Leiterbahnen auf eine Oberfläche der Leiterplatte aufdruckt und auf den ein Kontrollband 5 folgt. In einem ersten Bestückmodul 6 der Bauart Siplace HS50 werden auf die bedruckte Oberfläche der Leiterplatte passive Bauelemente aufgebracht. Die Bestückung wird in einem zweiten Bestückmodul 7 der Bauart Siplace 80S23HM ergänzt und schließlich können in einem dritten Bestückmodul 8 der Bauart Siplace 80F5HM noch aktive Bauelemente, wie ICs, auf die Leiterplatte aufgebracht werden, die eine hohe Genauigkeit erfordern. Die bedarfsgerecht bestückte Leiterplatte durchläuft dann einen Reflow-Ofen 10 in Tunnelbauweise, an den sich eine Wendestation 11 und schließlich eine Magazinausgabe 12 anschließt. Eine nur einseitig zu bestückende Leiterplatte wird von hier aus gegebenenfalls einer nicht gezeigten Station zur Restbestücküng zugeführt. Der Weg der Leiterplatten durch die Fertigungslinie bei einmaligem Durchlauf ist durch die Materialflußlinie A dargestellt.

Soll die Leiterplatte doppelseitig bestückt werden, kann das Magazin mit den gewendeten Leiterplatten manuell an den Eingang der Fertigungslinie zurücktransportiert werden, was durch die Materialflußlinie B dargestellt ist, von wo aus die gewendeten Leiterplatten die Fertigungslinie erneut durchlaufen (Materialflußlinie C) und nun auf der anderen Seite mit den gleichen Arbeitsschritten bestückt werden können, so daß schließlich beidseitig bestückte Baugruppen in das Magazin am Ende der Fertigungslinie ausgegeben werden und der Restbestückung zugeführt werden können.

Es kann aber auch auf die Wendestation 11 folgend eine weitere Fertigungslinie 1 angeschlossen werden, in der dann ohne den manuellen Magazinrücktransport die Bestückung der zweiten Leiterplattenseite erfolgen kann. In einer solchen kombinierten Fertigungslinie sind dann, falls beide Seiten der Leiterplatte auch mit "fine pitch"-Bauelementen bestückt werden sollen, je zwei Bestückmodule 6, 7 und 8, insgesamt also sechs Bestückmodule vorhanden.

Die erfindungsgemäße Fertigungslinie 13 ist in den Figuren 2 und 3 dargestellt, wobei sich diese Fertigungslinien 13 in den Figuren 2 und 3 nicht baulich unterscheiden, sondern nur hinsichtlich der Art ihrer Nutzung.

Die Fertigungslinie 13 setzt sich aus zwei aufeinanderfolgenden, unterschiedlichen Abschnitten 13a und 13b zusammen.

Der Abschnitt 13a beginnt mit einer Magazineingabe 2, auf die ein Leiterplattenentstapler 3 und ein Drucker 4 folgt. Von dort gelangen die Leiterplatten zu einem ersten Bestückmodul 6 der Bauart Siplace HS50, von wo aus sie über ein Durchgangsmodul 9 einem Vertikal-Reflow-Ofen 14 zugeführt werden. Über einen Puffer 15, ein Kontrollband 16 und eine Wendestation 11 werden die Leiterplatten an den zweiten Abschnitt 13b übergeben, wo sie zunächst einen weiteren Drucker 4 durchlaufen und dann über ein Band bzw. einen Platzhalter 17 dem zweiten Bestückmodul 7 der Bauart Siplace 80S23HM und dem darauf folgenden dritten Bestückmodul 8 der Bauart Siplace 80F5HM zugeführt-werden: Über-ein weiteres -Durchgangsmodul 9 erreichen die Leiterplatten einen zweiten Vertikal-Reflow-Ofen 14, aus dem sie einem Magazinpuffer 18 zugeführt werden.

Bei der in Figur 2 dargestellten Betriebsweise werden die Leiterplatten in einem einzigen Durchlauf durch die Fertigungslinie 13 bestückt.

Bei der Herstellung einer einseitigen Baugruppe wird im Abschnitt 13a die Oberseite der Leiterplatte bearbeitet, d.h. es wird im Drucker 4 die Oberseite der Leiterplatte bedruckt und im ersten Bestückmodul 6 die Oberseite der Leiterplatte bestückt. Wenn die Leiterplatte dann den Vertikal-Reflow-Ofen 14 des Abschnitts 13a durchlaufen, findet keine Lötung statt, da die Baugruppen an den Prozeßzonen vorbeigeführt werden. In der Wendestation 11 wird die Leiterplatte nicht gedreht. Der Drucker 4 des zweiten Abschnitts 13b wird ebenfalls funktionslos durchlaufen. Anschließend erfolgt die Bestückung in den Bestückmodulen 7 und 8 mit weiteren Bauelementen, bevor sie zum Vertikal-Reflow-Ofen des zweiten Abschnitts 13b gelangt, wo die Lötung der Leiterplatte erfolgt.

Bei der in einem Durchgang erfolgenden doppelseitigen Bestükkung werden die in den Abschnitt 13a eingebrachten Leiterplatten im Drucker 4 auf der Oberseite bedruckt und im ersten Bestückmodul 6 bestückt, worauf im ersten Vertikal-Reflow-Ofen 14 die Lötung dieser Bestückung stattfindet. In der Wendestation 11 wird die Leiterplatte umgewendet, die nun nach oben weisende, unbestückte Seite im Drucker 4 des zweiten Abschnitts bedruckt und in den Bestückmodulen 7 und 8 bestückt, worauf im Vertikal-Reflow-Ofen 14 des zweiten Abschnitts 13b die Lötung auch auf dieser Seite stattfindet, worauf die fertige, doppelseitig bestückte Baugruppe die Fertigungslinie 13 verläßt.

Bezeichnet man zur einfacheren Erläuterung alle durch das Bestückmodul 6 handhabbaren Bauelemente mit BE6, alle mit dem Bestückmodul 7 handhabbaren Bauelemente mit BE7 und alle mit dem Bestückmodul 8 handhabbaren Bauelemente mit BE8, so kann man feststellen, daß bei der einseitigen Bestückung einer Leiterplatte nach dem vorstehend anhand der Figur 2 beschriebenen Verfahren die bestückte Oberfläche Bauelemente BE6, BE7 und BE8 aufweisen kann. Bei der doppelseitigen Bestückung nach dem vorstehend beschriebenen Verfahren kann eine Oberfläche nur Bauelemente BE6 tragen und die andere Oberfläche Bauelemente BE7 und BE8.

Soll die mit BE6 bestückte Oberfläche auch Bauelemente BE7 und/oder BE8 erhalten, oder die mit BE7 und/oder BE8 bestückte Oberfläche auch Bauelemente BE6, wird die Fertigungslinie 13 von der zu bestückenden Leiterplatte zweimal durchlaufen, wie dies anhand der Figur 3 dargestellt ist.

Dabei wird in einem ersten Durchlauf die eine Seite mit Bauelementen BE6, BE7 und/oder BE8 bestückt, wobei der Verfahrensablauf demjenigen entspricht, der vorstehend für einseitige Bestückung beschrieben wurde, worauf dann die Leiterplatte gewendet und in einem zweiten Durchlauf die andere Seite in gleicher Weise bestückt wird.

Zweckmäßigerweise wird - falls diese Betriebsweise erwünscht ist - am Ende des Abschnitts 13b eine wahlweise zu- und abschaltbare weitere Wendestation 11 angeordnet, damit bei dieser Betriebsweise die Leiterplatten vor dem Rücktransport in der für den zweiten Durchlauf gewendeten Lage in das Magazin eingegeben werden.

## Patentansprüche

1. Fertigungslinie (13) für die einseitige und doppelseitige. Bestückung von Leiterplatten mit Bauelementen, wobei die Fertigungslinie (13) aus zwei aufeinanderfolgenden Abschnitten (13a, 13b) besteht, die jeweils in Durchlaufrichtung der Leiterplatten einen Drucker (4), wenigstens ein Bestückmodul (6, 7, 8) und einen Lötofen (14) umfassen, wobei zwischen den beiden Abschnitten (13a, 13b) eine Wendestation (11) angeordnet ist,
**dadurch gekennzeichnet,**
**daß** die der Handhabung unterschiedlicher Bauelemente zugeordneten Bestückmodule (6, 7, 8) in je einem Exemplar in der Fertigungslinie (13) vorgesehen und auf die beiden Abschnitte (13a, 13b) verteilt sind.

2. Fertigungslinie nach Anspruch 1,
**dadurch gekennzeichnet,**
**daß** die Lötöfen (14) Vertikal-Reflow-Öfen sind.

3. Fertigungslinie nach einem der Ausprüche 1 bis 2,
**dadurch gekennzeichnet,**
**daß** dem Lötofen (14) des zweiten Abschnitts (13b) eine weitere Wendestation (11) nachgeschaltet ist.

4. Fertigungslinie nach Anspruch 3,
**dadurch gekennzeichnet,**
**daß** die dem Lötofen (14) des zweiten Abschnitts (13b) nachgeschaltetete weitere Wendestation (11) wahlweise zu- und abschaltbar ist.

## Claims

1. Production line (13) for one-sided and two-sided assembly of printed circuit boards with components, the production line (13) consisting of two successive sections (13a, 13b), each comprising a printer (4), at least one assembly module (6, 7, 8) and a soldering furnace (14), in the direction in which the printed circuit boards pass through, a turning station (11) being arranged between the two sections (13a, 13b), **characterized in that** one of each of the assembly modules (6, 7, 8) allocated to the handling of different components is provided in the production line (13) and said modules are distributed between the two sections (13a, 13b).

2. Production line according to Claim 1, **characterized in that** the soldering furnaces (14) are vertical reflow furnaces.

3. Production line according to either of Claims 1 and 2, **characterized in that** a further turning station (11) is arranged downstream of the soldering furnace (14) of the second section (13b).

4. Production line according to Claim 3, **characterized in that** the further turning station (11) arranged downstream of the soldering furnace (14) of the second section (13b) can be switched on and off according to choice.

## Revendications

1. Ligne de production (13) destinée à l'équipement, sur une face et sur deux faces, de plaquettes de circuits imprimés avec des composants, la ligne de production (13) se composant de deux sections successives (13a, 13b) qui comprennent respectivement, dans le sens du passage des plaquettes de circuits imprimés, une imprimante (4), au moins un module de pose (6, 7, 8) et un four de brasage (14), une station de retournement (11) étant située entre les deux sections (13a, 13b), **caractérisée en ce que** les modules de pose (6, 7, 8) affectés au maniement de composants différents sont prévus chacun en un exemplaire sur la ligne de production (13) et sont répartis sur les deux sections (13a, 13b).

2. Ligne de production selon la revendication 1, **caractérisée en ce que** les fours de brasage (14) sont des fours reflow verticaux.

3. Ligne de production selon l'une des revendications 1 à 2, **caractérisée en ce qu'**une autre station de retournement (11) est montée en aval du four de brasage (14) de la deuxième section (13b).

4. Ligne de production selon la revendication 3, **caractérisée en ce que** l'autre station de retournement (11) montée en aval du four de brasage (14) de la deuxième section (13b) est enclenchable et désenclenchable au choix.
